# EUROPÄISCHE PATENTSCHRIFT

(11) **EP 1 152 839 B1**
(45) Veröffentlichungstag und Bekanntmachung des Hinweises auf die Patenterteilung: **13.11.2002**
(21) Anmeldenummer: 00903586.6
(22) Anmeldetag: 19.01.2000
(51) Int. Cl.: B05C 11/08, G03F 7/16

(54) **VERFAHREN UND VORRICHTUNG ZUM BEHANDELN VON SUBSTRATEN**
METHOD AND DEVICE FOR TREATING SUBSTRATES
PROCEDE ET DISPOSITIF POUR LE TRAITEMENT DE SUBSTRATS

(30) Priorität: 16.02.1999 DE 19906398
(43) Veröffentlichungstag der Anmeldung: 14.11.2001
(73) Patentinhaber: Steag HamaTech AG, 75447 Sternenfels (DE)
(72) Erfinder: DRESS, Peter, D-76646 Bruchsal (DE); APPICH, Karl, D-75447 Diefenbach (DE); KRAUSS, Peter, D-75447 Sternenfels (DE); SZEKERESCH, Jakob, D-75328 Schönberg (DE); WEIHING, Robert, D-75417 Mühlacker (DE)
(74) Vertreter: Wagner, Karl H., Dipl.-Ing.
(86) Internationale Anmeldenummer: EP0000380
(87) Internationale Veröffentlichungsnummer: WO00048744

(56) Entgegenhaltungen:
- US-A- 5 445 677
- PATENT ABSTRACTS OF JAPAN vol. 016, no. 423 (E-1260), 7. September 1992 (1992-09-07) & JP 04 146615 A (TATSUMO KK), 20. Mai 1992 (1992-05-20)
- PATENT ABSTRACTS OF JAPAN vol. 005, no. 133 (E-071), 25. August 1981 (1981-08-25) & JP 56 070634 A (MATSUSHITA ELECTRIC IND CO LTD), 12. Juni 1981 (1981-06-12)
- PATENT ABSTRACTS OF JAPAN vol. 017, no. 413 (C-1092), 3. August 1993 (1993-08-03) & JP 05 084460 A (TOKYO OHKA KOGYO CO LTD), 6. April 1993 (1993-04-06)
- "UPSIDE-DOWN RESIST COATING OF SEMICONDUCTOR WAFERS" IBM TECHNICAL DISCLOSURE BULLETIN,US,IBM CORP. NEW YORK, Bd. 32, Nr. 1, 1. Juni 1989 (1989-06-01), Seiten 311-313, XP000033192 ISSN: 0018-8689

## Beschreibung

Die vorliegende Erfindung bezieht sich auf ein Verfahren und eine Vorrichtung zum Beschichten von Substraten, bei dem das Substrat derart an einem Substrathalter gehalten ist, daß die zu beschichtende Substratfläche frei liegt und das Substrat mit dem Substrathalter gedreht wird.

Eine derartige Vorrichtung ist beispielsweise aus der EP-A 0 711 108 bekannt. Diese Vorrichtung umfaßt eine Vorbelackungsstation, bei der eine nach unten weisende, zu beschichtende Substratfläche an einem mit Lack gespeisten Kapillarspalt vorbeibewegt wird, um die Substratfläche zu belacken. Anschließend wird das Substrat zu einer Schleuderstation bewegt und innerhalb eines Schutzrings, der dazu dient, von dem Substrat abgeschleuderte Lackreste abzuleiten, gedreht bzw. geschleudert.

Die DE-A-195 45 573 zeigt eine Vorrichtung zum gleichmäßigen Aufbringen einer Lackschicht auf einem Substrat, bei der ein Substrat mit der zu beschichtenden Seite nach oben weisend auf einem Drehteller aufliegt. Während eines Schleudervorgangs wird eine das Substrat zumindest teilweise abdeckende Haube von oben mit geringem Abstand über das Substrat bewegt oder direkt auf dem Substrat positioniert.

Aus der DE-A-92 18 974 ist ebenfalls eine Vorrichtung zum Aufbringen einer dünnen Schicht, wie beispielsweise eines Lacks, auf einem Substrat mittels einer Schleudervorrichtung bekannt. Die Vorrichtung weist einen Drehteller auf, auf dem ein zu beschichtendes Substrat mit der zu beschichtenden Oberfläche nach oben weisend angeordnet ist. Eine Haube ist von oben her auf dem Drehteller positionierbar, um einen Raum zur Aufnahme des Substrats zu bilden. Dabei ist der zwischen der Haube und dem Drehteller gebildete Raum über Durchbrechungen in dem Drehteller mit der Umgebung verbunden. Darüber hinaus sind an der Haube elastische Abdeckleisten vorgesehen, welche mit nach oben weisenden Kanten des Substrats in Kontakt stehen, um einen Raum zwischen der Abdeckung und dem Substrat zu bilden.

Die US-A-5 042 421 zeigt eine Drehkopfanordnung zum Beschichten eines Halbleiters, mit einem Drehteller zur Auflage des Wafers und einer den Wafer umgebenden Scheibe, die auf dem Drehteller befestigbar ist.

Die DE-A-40 24 642 zeigt ferner einen Drehteller zur Aufnahme eines Substrats, das mittels eines Vakuums am Drehteller gehalten wird.

Bei diesen Vorrichtungen ergibt sich das Problem, daß die durch den Schleudervorgang erreichte Gleichmäßigkeit der Schichtdicke nicht in allen Fällen ausreichend hoch ist.

Demgemäß liegt der vorliegenden Erfindung die Aufgabe zugrunde, ein Verfahren und eine Vorrichtung der oben genannten Art zum Behandeln von Substraten anzugeben bzw. zu schaffen, bei dem bzw. bei der eine homogene Beschichtung der zu behandelnden Substratfläche erreicht wird.

Erfindungsgemäß wird die gestellte Aufgabe dadurch gelöst, daß eine am Substrathalter befestigbare Abdeckung, die gemeinsam mit dem Substrathalter eine abgedichtete, das Substrat aufnehmende Kammer bildet, vorgesehen wird. Durch die am Substrathalter befestigbare Abdeckung werden zwischen dem Substrathalter und der Abdeckung definierte Umgebungsbedingungen für das Substrat erreicht. Insbesondere wird innerhalb der Kammer ein stehender Bereich derart gebildet, daß sich die darin befindlichen Gase, wie beispielsweise Luft gemeinsam mit dem Substrathalter und der daran befestigten Abdeckung drehen. Ferner wird der Abstand zwischen der zum Substrat weisenden Seite der Abdeckung während des Drehvorgangs auf einem konstanten definierten Wert gehalten. Hierdurch werden Relativbewegungen und Verwirbelungen zwischen dem Substrat und in der Kammer befindlichen Gasen auf ein Minimum reduziert, was zu einer sehr homogenen Beschichtung des Substrats führt. Dabei ist es unerheblich, ob die gesamte zu beschichtende Substratfläche vorbeschichtet ist oder ob nur ein Teilbereich, wie beispielsweise der Mittelbereich der Substratfläche vorbeschichtet ist, und die vollständige Beschichtung mittels des Drehvorgangs erfolgt. Die definierten Umgebungsbedingungen für das Substrat erlauben ferner ein gleichmäßigeres und allmähliches Abtrocknen eines in der Beschichtung enthaltenen Lösungsmittels. Indem die zu beschichtende Oberfläche nach unten weisend gehalten wird, wird ferner sichergestellt, daß vom Substrat abgelöstes Beschichtungsmedium nicht mit Seitenkanten oder der Rückseite des Substrats in Kontakt kommt.

Um einen guten Halt des Substrats am Substrathalter sicherzustellen, ohne die zu beschichtende Substratfläche zu beeinträchtigen, weist der Substrathalter eine Halteeinrichtung zum Halten des Substrats mit Unterdruck auf.

Gemäß einer bevorzugten Ausführungsform der Erfindung weist der Substrathalter ferner eine Halteeinrichtung zum Halten der Abdeckung mit Unterdruck auf. Vorteilhafterweise sind die Halteeinrichtungen für das Substrat und die Abdeckung mit einer gemeinsamen Unterdruckversorgung verbunden, um nur eine Vakuumquelle, wie z. B. eine Vakuumpumpe, vorsehen zu müssen. Dabei sind die Halteeinrichtungen für das Substrat und die Abdeckung vorzugsweise unabhängig voneinander ansteuerbar, beispielsweise über eine Ventileinheit, da die Abdeckung nur für den Dreh- bzw. Schleudervorgang am Substrathalter befestigt wird, während das Substrat über längere Zeiten, insbesondere auch bei einer Vorbeschichtung, am Substrathalter gehalten wird.

Um einen gut definierten Unterdruckbereich zwischen dem Substrathalter und der Abdeckung und somit einen guten Halt zu erreichen, ist zwischen Substrathalter und Abdeckung eine Dichtung vorgesehen.

Bei einer Ausführungsform der Erfindung ist im Substrathalter eine Vertiefung zur wenigsten teilweisen Aufnahme des Substrats vorgesehen, über die eine Zentrierung des Substrats bezüglich des Halters erreichbar ist. Ferner kann die Vertiefung dem Substrat beim Dreh- bzw. Schleudervorgang seitlichen Halt bieten.

Vorzugsweise weist die Vorrichtung eine Zentriereinrichtung zum gegenseitigen Zentrieren der Abdeckung und des Substrathalters auf, um eine definierte Lage der Abdeckung zum Substrathalter sowie zum Substrat sicherzustellen. Für eine kostengünstige und einfache Zentrierung weist die Zentriereinrichtung vorzugsweise wenigstens eine Zentrierschräge an der Abdeckung und/oder am Substrathalter auf. Um eine Unwucht und eine seitliche Verschiebung der Abdeckung bezüglich des Substrathalters bei der Drehung desselben zu verhindern, ist die Abdeckung vorzugsweise zu einer Mittelachse symmetrisch.

Bei einer besonders bevorzugten Ausführungsform der Erfindung ist im Außenbereich des die Kammer definierenden Teils der Abdeckung eine Aussparung vorgesehen, um einen ausreichenden Raum für abgeschleuderte Lackreste zu bilden. Die Ausbildung der Aussparung im Außenbereich stellt sicher, daß die Lackreste durch die beim Drehen entstehenden Zentrifugalkräfte sicher aus dem Bereich des Substrats und auch des Substrathalters weg geleitet werden, um sie vor Verunreinigungen zu schützen. Dabei verjüngt sich die Aussparung vorzugsweise nach außen derart, daß die zum Substrathalter weisende Seite abgeschrägt ist. Hierdurch wird die Ableitung des Lacks vom Substrat und vom Substrathalter noch verbessert.

Bei einer weiteren besonders bevorzugten Ausführungsform der Erfindung ist die Abdeckung zu ihrer horizontalen Mittelebene symmetrisch, und es ist eine Einrichtung zum Wenden der Abdeckung vorgesehen, so daß die Abdeckung in einer ersten Position und in einer um 180° gewendeten Position einsetzbar ist. Vorzugsweise ist eine höhenmäßig verstellbare Aufnahme zum Halten der Abdeckung vorgesehen, um diese zwischen den Drehvorgängen, bei denen sie an dem Substrathalter befestigt ist, zu halten. Um eine Reinigung der Abdeckung während oder zwischen den jeweiligen Schleudervorgängen zu ermöglichen, ist eine Spül- und/oder Trocknungsvorrichtung für die Abdeckung vorgesehen. Das Spülen und/oder Trocknen verhindert eine Verunreinigung des nachfolgend zu behandelnden Substrats durch an der Abdeckung anhaftende Verunreinigungen. Bei einer besonders vorteilhaften Ausgestaltung der Erfindung ist die Spül- und/oder Trocknungsvorrichtung Teil der Aufnahme und weist wenigstens eine auf die Abdeckung und/oder die Aussparung gerichtete Düse auf. Das Richten einer Düse auf die Aussparung ist besonders vorteilhaft, da sich - wie oben ausgeführt - Lackreste bevorzugt in diesen Aussparungen ansammeln und diese mit der Zeit ausfüllen würden, wenn sie nicht gereinigt würden. Vorzugsweise ist wenigstens eine Düse mit einem ein Lösungsmittel enthaltenden Spülfluid beaufschlagbar, um die Lackreste zu entfernen. Nach der Spülung wird vorzugsweise ein Trocknungsfluid über dieselbe oder eine weitere Düse auf die Abdeckung gerichtet, um diese zu trocknen.

Die erfindungsgemäße Aufgabe wird auch durch ein Verfahren zum Behandeln von Substraten, bei dem das Substrat derart an einem Substrathalter gehalten ist, daß die zu behandelnde Substratfläche frei liegt und nach unten weist, und das Substrat mit dem Substrathalter gedreht wird, dadurch gelöst, daß eine Abdeckung am Substrathalter, die gemeinsam mit dem Substrathalter eine abgedichtete Kammer für das Substrat bildet, befestigt wird. Durch die Befestigung der Abdeckung am Substrathalter und die Bildung der abgeschlossenen Kammer ergeben sich die schon oben ausgeführten Vorteile.

Bei einer besonders vorteilhaften Ausführungsform der Erfindung wird die vom Substrat abgewandte Seite der Abdeckung während des Drehvorgangs gespült und/oder getrocknet. Durch die gleichzeitige Spülung und/oder Trocknung mit dem Drehvorgang ergibt sich eine Zeitersparnis, da die Spülung und/oder Trocknung nicht in einem Zwischenschritt ausgeführt werden muß. Darüber hinaus fördern die durch den Drehvorgang entstehenden Zentrifugalkräfte die Spülung und/oder Trocknung.

Vorzugsweise wird die Abdeckung zwischen aufeinanderfolgenden Drehyorgängen gewendet, so daß immer eine gereinigte Seite der Abdeckung zu dem zu behandelnden Substrat weist, während die vom vorhergehenden Drehvorgang verschmutzte Seite vom Substrat abgewandt ist und gereinigt werden kann.

Die Erfindung eignet sich besonders für die Dünnschichttechnik, insbesondere für die Herstellung von LCD-Bildschirmen, Masken für die Halbleiterfertigung, Halbleiter- oder Keramiksubstraten, um dort rechteckige oder runde Platten mit einer gleichmäßigen Schicht aus Lack oder anderen zunächst flüssigen Medien, wie Farbfiltern oder speziellen Schutzschichten zu versehen.

Die Erfindung wird nachfolgend anhand bevorzugter Ausführungsbeispiele unter Bezugnahme auf die Zeichnungen erläutert; in den Zeichnungen zeigt:
- Fig. 1: eine schematische Darstellung der erfindungsgemäßen Vorrichtung, bei der ein ein Substrat tragender Substrathalter und eine Abdeckung voneinander entfernt sind;
- Fig. 2: eine weitere schematische Darstellung der erfindungsgemäßen Vorrichtung gemäß Fig. 1, wobei die Abdeckung mit dem Substrathalter in Kontakt steht;
- Fig. 3: eine weitere schematische Darstellung der erfindungsgemäßen Vorrichtung gemäß Fig. 1, wobei die Abdeckung am Substrathalter befestigt ist und sich mit diesem dreht;
- Fig. 4: eine weitere Darstellung der erfindungsgemäßen Vorrichtung gemäß Fig. 1, wobei die Abdeckung wieder vom Substrathalter entfernt ist und der Substrathalter von der Abdeckung weg bewegt wird;
- Fig. 5: eine schematische Darstellung der erfindungsgemäßen Abdekkung und einer Aufnahme für die Abdeckung, wobei die Abdekkung während eines Wendevorgangs gezeigt ist;
- Fig. 6: eine schematische Darstellung der Abdeckung und der Aufnahme, bei der die Abdeckung auf der Aufnahme abgelegt ist;
- Fig. 7: eine vergrößerte Schnittdarstellung eines weiteren Ausführungsbeispiels der Erfindung, die den Substrathalter und die Abdekkung zeigt, in schematischer Darstellung; und
- Fig. 8: eine Draufsicht auf die erfindungsgemäße Abdeckung gemäß Fig. 7.

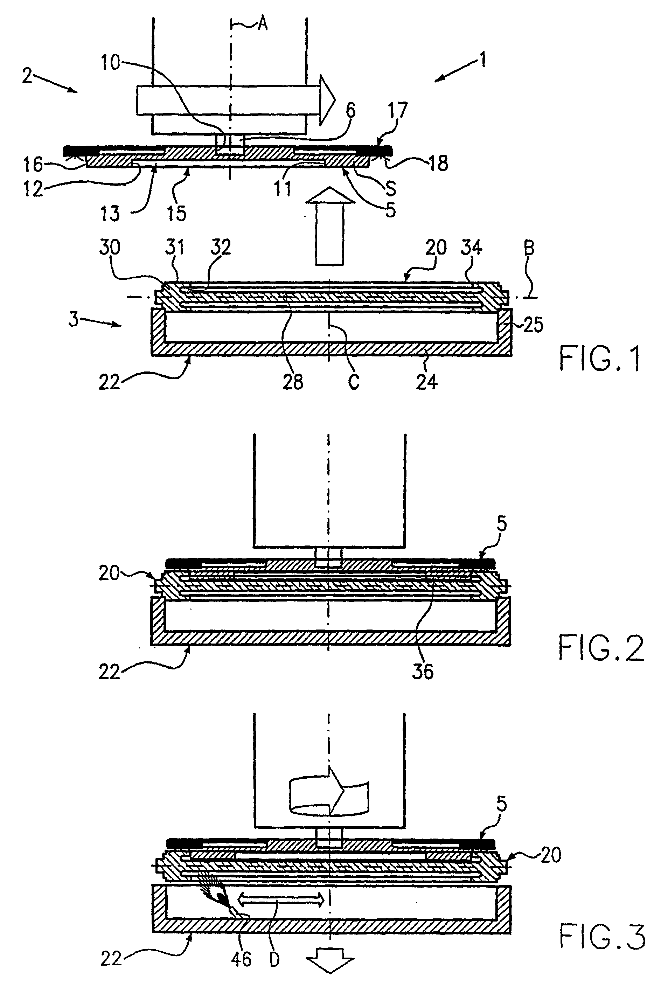

Die Fig. 1 bis 6 zeigen einen Funktionsablauf für die erfindungsgemäße Beschichtungsvorrichtung 1 der Erfindung. Die Vorrichtung 1 besteht im wesentlichen aus einer Substrataufnahme- und Transporteinheit 2 und einer Abdeckeinheit 3.

Die Aufnahme- und Transporteinheit 2 besitzt eine nicht näher dargestellte Transportvorrichtung und einen Substrathalter 5, der über eine Drehwelle 6 mit einer nicht näher dargestellten Drehvorrichtung gekoppelt ist. Die Drehvorrichtung steht mit der Transportvorrichtung in Verbindung und ist damit bewegbar. Eine derartige Aufnahme- und Transporteinheit mit Transportvorrichtung, Drehvorrichtung und Substrathalter ist beispielsweise aus der zuvor genannten EP-A-0 711 108 bekannt, auf die zur Vermeidung von Wiederholungen insofern Bezug genommen wird.

Der Substrathalter 5 besteht aus einer Grundplatte 8, die auf ihrer zur Transportvorrichtung weisenden Oberseite eine Ausnehmung 10 zur entsprechenden Aufnahme der Drehwelle 6 aufweist. Der Substrathalter 5 ist bezüglich einer Drehachse A der Drehwelle 6 rotationssymmetrisch ausgebildet. In der von der Transportvorrichtung weg weisenden Unterseite 11 der Grundplatte 8 ist eine Ausnehmung 12 zur Aufnahme eines Substrats 13 ausgebildet. Das Substrat 13 wird so in der Ausnehmung 12 aufgenommen, daß eine zu beschichtende Oberfläche 15 des Substrats vom Substratträger weg weist und frei liegt. Die Tiefe der Ausnehmung 12 entspricht der Dicke des aufzunehmenden Substrats, so daß die Unterseite 11 der Grundplatte 8 bei eingesetztem Substrat 13 mit der zu beschichtenden Oberfläche 15 des Substrats fluchtet. Wahlweise kann die Unterseite 15 aber auch von der durch die Unterseite 11 des Grundkörpers 8 definierten Ebene beabstandet sein, insbesondere über die Unterseite 11 nach unten vorstehen. Das Substrat 13 wird über nicht dargestellte Vakuumöffnungen, die in der Grundplatte 8 ausgebildet sind und mit einer nicht näher dargestellten Unterdruckquelle, wie z. B einer Vakuumpumpe, verbunden sind, am Substrathalter 5 gehalten.

Die Grundplatte 8 besitzt einen leicht konischen, sich nach unten verjüngenden Außenumfang 16, der, wie nachfolgend beschrieben wird, als Zentrierschräge dient.

Der Substrathalter 5 weist neben den Vakuumöffnungen zum Halten des Substrats 13 eine weitere Vakuumhaltevorrichtung 17 mit napfförmigen Vakuumgreifern 18 auf, die über nicht näher dargestellte Leitungen mit einer Unterdruckquelle in Verbindung stehen. Diese Unterdruckquelle ist dieselbe wie die, die mit den Vakuumöffnungen zum Halten des Substrats 13 in Verbindung steht. Die Vakuumgreifer 18 sind jedoch über Ventile unabhängig von den Vakuumöffnungen zum Halten des Substrats 13 mit Unterdruck beaufschlagbar. Die Vakuumgreifer 18 liegen radial benachbart zu der Grundplatte 8 des Substrathalters 5 und sind bezüglich der Unterseite 11 zurückgesetzt. Obwohl in Fig. 1 nur zwei Vakuumgreifer 18 dargestellt sind, sei bemerkt, daß eine Vielzahl von Vakuumgreifern 18 rotationssymmetrisch um den Umfang des Substrathalters 5 herum vorgesehen ist. Statt der Verwendung einer gemeinsamen Unterdruckquelle für die Vakuumhalter 18 und die Vakuumöffnungen für das Substrat könnten auch zwei getrennte Unterdruckquellen verwendet werden.

Die Abdeckeinheit 3 besteht im wesentlichen aus einem Abdeckelement, kurz einer Abdeckung 20 und einem die Abdeckung aufnehmenden Aufnahmeelement bzw. einer Aufnahme 22. Die Aufnahme 22 besitzt - wie in Fig. 1 gezeigt ist - einen beckenförmigen Querschnitt mit einer Bodenplatte 24 und einer sich senkrecht dazu erstreckenden Seitenwand 25.

Die Abdeckung 20 besitzt eine Mittelwand 28 mit einer horizontalen Mittelebene B. Die Abdeckung 20 ist bezüglich der horizontalen Mittelebene B symmetrisch, so daß nur der obere Teil der Abdeckung beschrieben wird. Von der Mittelwand 28 aus erstreckt sich rotationssymmetrisch bezüglich einer Mittelachse C der Abdeckung 20 ein Flansch 30 nach oben. Der Flansch 30 bildet eine ebene Fläche 31, die - wie nachfolgend beschrieben wird - mit den Vakuumgreifern in Kontakt gebracht wird, um dazwischen eine Verbindung zu erzeugen. Benachbart zu der Mittelwand 28 weist der Flansch 30 eine bezüglich der Mittelachse C rotationssymmetrisch ausgebildete Aussparung 32 auf. Die Aussparung 32 ist fluchtend mit der Mittelwand 28 ausgebildet. Durch die Aussparung 32 wird an dem Flansch 30 ein oberhalb der Aussparung 32 befindlicher, rotationssymmetrischer Radialvorsprung 34 gebildet, der einen Teil der ebenen Fläche 31 bildet. Der Innenumfang des Vorsprungs 34 ist dem Außenumfang der Grundplatte 8 angepaßt, so daß die Grundplatte 8 zwischen dem Vorsprung 34 des Flansches 30 aufgenommen werden kann, wobei der sich verjüngende Außenumfang eine Zentrierung zwischen Substrathalter 5 und Abdeckung 20 bewirkt.

Wenn die Grundplatte 8 des Substrathalters 5 in der Abdeckung aufgenommen ist, kommen die Vakuumgreifer 18 mit der ebenen Fläche 31 des Flansches 30 in Eingriff. In dieser Position wird zwischen dem Substrathalter 5 und der Abdeckung 20 eine Kammer 36 gebildet, wie beispielsweise in Fig. 2 dargestellt ist. In dieser Position werden die Vakuumgreifer 18 mit Unterdruck beaufschlagt, so daß die Abdeckung 20 fest an dem Substrathalter 5 gehalten ist.

Wie in Fig. 3 gezeigt ist, ist innerhalb der Aufnahme 22 eine auf die Unterseite, insbesondere auf die Aussparung der Abdeckung 20 gerichtete Düse 40 vorgesehen, über die ein Spül- und/oder Trocknungsfluid auf die Unterseite der Abdeckung 20 gespritzt wird. Die Düse 40 ist innerhalb der Aufnahme 22 bewegbar, wie durch den Pfeil D angezeigt ist. Statt der einen Düse kann auch eine Vielzahl von Düsen vorgesehen sein.

Die Abdeckeinheit 3 weist ferner eine nicht dargestellte Wendevorrichtung zum Wenden der Abdeckung 20 um die Mittelebene B auf, wie in Fig. 5 dargestellt ist.

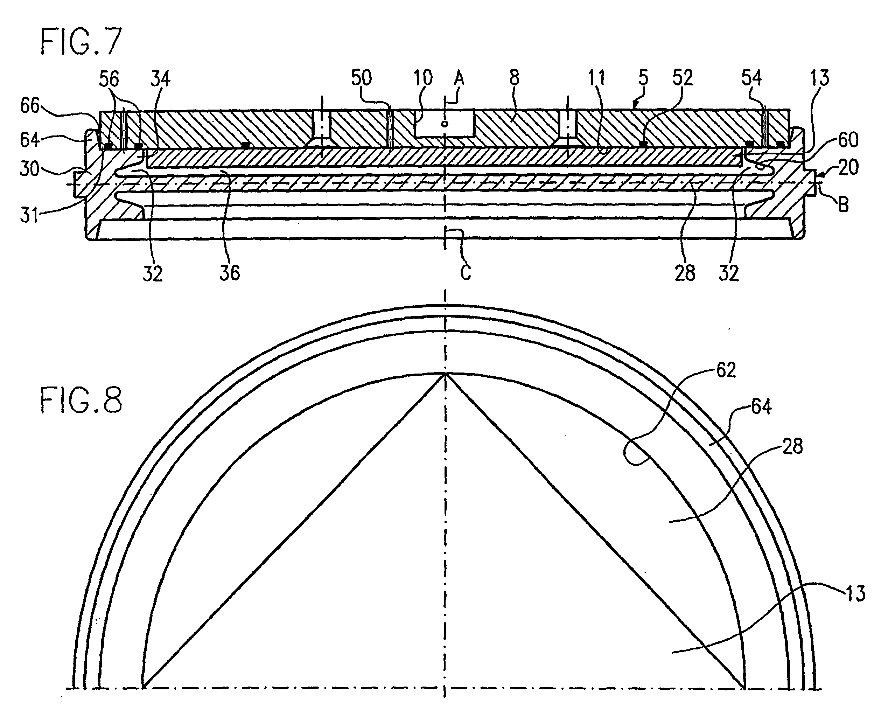

In Figuren 7 und 8 ist eine alternative Ausführungsform des Substrathalters 5 mit einer alternativen Ausführungsform der Abdeckung 20 dargestellt. In den Figuren 7 und 8 werden dieselben Bezugszeichen wie in den Fig. 1 bis 6 verwendet, soweit ähnliche oder gleiche Elemente betroffen sind.

Der Substrathalter 5 weist wiederum eine Grundplatte 8 auf, die auf ihrer Oberseite eine Ausnehmung 10 zur Aufnahme einer Drehwelle aufweist. Im Gegensatz zu dem Ausführungsbeispiel der Fig. 1 bis 6 weist die zum Substrat weisende Unterseite 11 des Hauptkörpers 8 keine Ausnehmung zur Aufnahme des Substrats 13 auf. Die Unterseite 11 ist flach ausgebildet, und das Substrat 13 wird über Vakuumöffnungen 50 in dem Hauptkörper 11 an der Grundplatte 8 gehalten. Die Vakuumöffnungen 50 stehen, wie bei dem ersten Ausführungsbeispiel gemäß den Fig. 1 bis 6, mit einer Unterdruckquelle in Eingriff. In der Unterseite 11 des Hauptkörpers 8 ist eine die Vakuumöffnungen 50 umgebende Nut zur Aufnahme eines Dichtelements, wie beispielsweise eines O-Rings 52 ausgebildet.

Im Außenbereich des Grundkörpers 8 des Substrathalters 5 sind mit einer Unterdruckquelle in Verbindung stehende Vakuumöffnungen 54 ausgebildet, welche die Vakuumgreifer 18 gemäß den Fig. 1 bis 6 ersetzen. Obwohl in Fig. 7 nur zwei Vakuumöffnungen 54 dargestellt sind, sei bemerkt, daß eine Vielzahl von Vakuumöffnungen 54 rotationssymmetrisch zu der Drehachse A des Substrathalters 5 vorgesehen ist. In der Unterseite 11 sind benachbart zu den Vakuumöffnungen 54 zwei umlaufende Nuten zur Aufnahme von Dichtelementen 56, wie beispielsweise O-Ringen vorgesehen.

Die Abdeckung 20 weist wiederum eine Mittelwand 28 mit einer Mittelebene B auf, zu der die Ober- und Unterseite der Abdeckung 20 symmetrisch sind. Daher wird wiederum nur der Oberteil der Abdeckung 20 beschrieben. Im Außenbereich der Mittelwand 28 erstreckt sich wiederum ein umlaufender Flansch 30 mit einer ebenen Oberseite 31 nach oben. Der Flansch ist bezüglich der Mittelachse C, die gemäß Fig. 7 mit der Rotationsachse A des Substrathalters 5 zusammenfällt, rotationssymmetrisch. Der Flansch 30 weist wiederum eine benachbart zu der Mittelwand liegende und mit dieser fluchtende Aussparung 32 auf. Durch die Aussparung 32 wird ein nach innen ragender Vorsprungs 34 des Flansches 30 gebildet. Der Innenumfang 62 des Vorsprungs ist derart bemessen, daß ein zu beschichtendes Substrat B ohne Kontakt mit dem Vorsprung dazwischen aufnehmbar ist. Die Aussparung 32 weist eine schräge Oberseite 60 auf, so daß sich die Aussparung 32 radial nach außen verjüngt.

Der Flansch 30 weist einen weiteren sich axial von der ebenen Oberseite 31 erstreckenden Vorsprung 64 auf, der eine sich nach unten verjüngende Innenumfangsfläche 66 definiert. Die sich nach unten verjüngende Innenumfangsfläche 66 ist an die Außenumfangsform des Grundkörpers 8 des Substrathalters 5 angepaßt und bildet eine Zentrierschräge, so daß der Hauptkörper 5 entlang der Innenumfangsfläche 66 gleiten kann, bis die Unterseite 11 des Grundkörpers 8 des Substrathalters 5 auf der ebenen Oberseite 31 des Flansches 30 der Abdeckung 20 aufliegt. Durch die sich verjüngende Innenumfangsform wird eine Zentrierung des Substrathalters 5 bezüglich der Abdekkung 20 und somit eine Zentrierung des Substrats 13 bezüglich des Substrathalters 5 gewährleistet.

Obwohl gemäß Fig. 7 Dichtungen 56 in dem Grundkörper 8 vorgesehen sind, könnten diese in gleicher Weise in Ausnehmungen in der ebenen Oberseite 31 der Abdeckung 20 ausgebildet sein.

Fig. 8, welche eine Draufsicht auf die Abdeckung 20 zeigt, verdeutlicht neben der kreisrunden Form auch die Lage der ebenen Oberseite 31 des Flansches 30, welche den Vakuumbereich bildet, der die Haftung der Abdeckung am Substrathalter gewährleistet. Eine Verschmutzung dieses Bereichs ist bedingt durch seine Lage nahezu ausgeschlossen.

Anhand der Fig. 1 bis 6 wird nun ein Funktionsablauf des erfindungsgemäßen Beschichtungsverfahrens beschrieben, wobei der Ablauf in gleicher Weise für die Elemente gemäß Fig. 7 gilt.

In Fig. 1 wird die Substrataufnahme- und Transporteinheit 2 über die Abdeckeinheit 3 bewegt, welche über eine nicht dargestellte Hubvorrichtung in Richtung der Substrataufnahme- und Transporteinheit angehoben wird, wie durch die jeweiligen Pfeile angezeigt ist. Die Substratfläche 15 ist zu diesem Zeitpunkt, beispielsweise durch einen CapCoating Vorgang, wie er in der zuvor genannten EP-A-0 711 108 beschrieben ist, vorbeschichtet. Durch den CapCoating Vorgang wird beispielsweise eine gleichmäßige Schicht in einem Dikkenbereich von 1µm bis 2µm auf die zu beschichtende Substratfläche aufgebracht.

Der Substrathalter 5 wird mit der Abdeckung 20 in Kontakt gebracht, wie in Fig. 2 gezeigt ist, und über die Zentrierschräge 16 am Substrathalter bzw. die Zentrierschräge 66 an der Abdeckung zentriert, so daß die Drehachse A des Substrathalters und die Mittelachse C der Abdeckung zusammenfallen. Dann wird die Abdeckung 20 durch Unterdruck - entweder über die Vakuumgreifer 18 oder die Vakuumöffnungen 54 - angesaugt und fest am Substrathalter 5 gehalten. Dadurch wird zwischen Substrathalter 5 und Abdeckung 20 eine hermetisch abgeschlossene Kammer 36 gebildet, die am besten in Fig. 7 zu sehen ist.

Anschließend wird, wie in Fig. 3 gezeigt ist, die Aufnahme 22 leicht abgesenkt, so daß die Abdeckung 20 nicht mehr mit der Aufnahme 22 in Kontakt steht. Dann wird der Substrathalter über die nicht dargestellte Drehvorrichtung gemeinsam mit dem daran befestigten Substrat 13 und der Abdeckung 20 gedreht, wobei von der vorbeschichteten Oberfläche 15 des Substrats 13 überschüssiges Material abgeschleudert wird, welches sich infolge der Zentrifugalkraft innerhalb der Aussparung 32 der Abdeckung 20 ansammelt. Dadurch, daß sich das Substrat 13 während des Schleudervorgangs in der hermetisch abgeschlossenen Kammer 36 befindet, wird eine homogene Beschichtung des Substrats mit Abweichungen hinsichtlich der Dicke der Beschichtung von kleiner 1 % bei Schichtdicken im Bereich von 0,2µm bis 1,0µm über die gesamte Substratfläche erreicht. Insbesondere wird die Gleichmäßigkeit der Beschichtung in den Eckbereichen von rechteckigen Substraten verbessert. Es verbleibt nur ein kleiner Randbereich von weniger als 2mm, in dem die Gleichmäßigkeit der Beschichtung nicht voll gewährleistet werden kann.

Gleichzeitig wird über die Düse 40 eine ein Lösungsmittel enthaltende Spülflüssigkeit auf die Unterseite der Abdeckung 20 gespritzt, um diese zu reinigen. Die Reinigungswirkung wird dabei durch die Drehung der Abdeckung 20 gefördert. Nach dem Aufspritzen der Spülflüssigkeit wird ein Trocknungsfluid auf die Unterseite der Abdeckung geleitet werden, um diese zu trocknen.

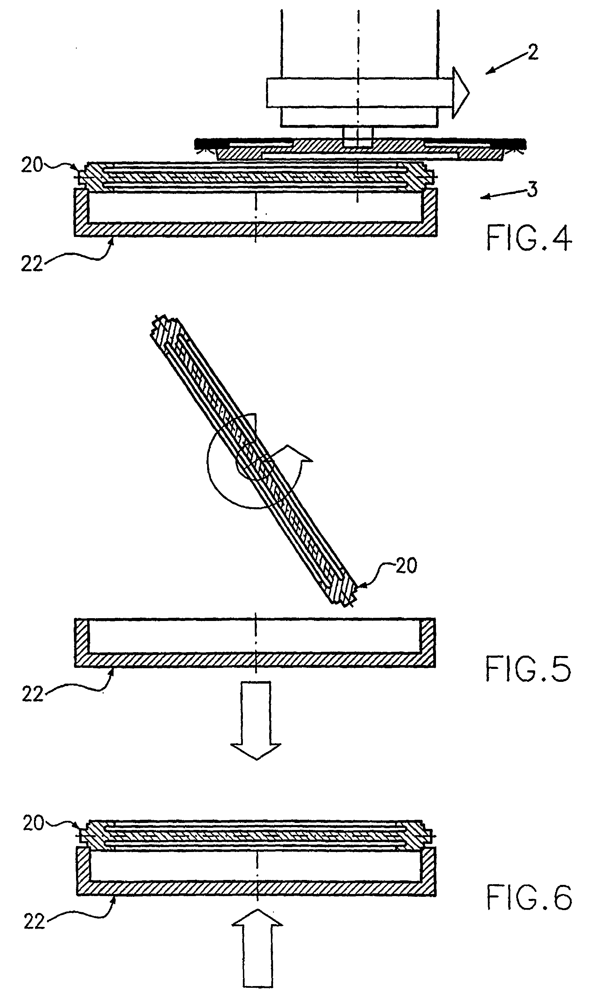

Wie in Fig. 4 gezeigt ist, wird die Abdeckung 20 nach dem Schleudervorgang wieder auf der Aufnahme 22 abgelegt, und die Substrataufnahme- und Transporteinheit 2 wird aus dem Bereich der Abdeckeinheit 3 weg bewegt. Wie in Fig. 5 zu sehen ist, wird die Abdeckung 20 mittels einer nicht näher dargestellten Wendevorrichtung um 180° bezüglich der horizontalen Mittelebene gewendet, während die Aufnahme 22 abgesenkt ist, um das Wenden zu ermöglichen.

Wie in Fig. 6 gezeigt ist, wird die Aufnahme 22 nach dem Wendevorgang wieder angehoben, und die Abdeckung 20 auf der Aufnahme 22 abgelegt. Nach dem Wendevorgang weist die zuvor gereinigte Seite der Abdeckung 20 nach oben, während die durch den vorhergehenden Schleudervorgang verschmutzte Seite nach unten weist. Somit ist die Abdeckung 20 bereit für ihren Einsatz in einem neuen Schleudervorgang.

Wie aus der obigen Beschreibung zu entnehmen ist, besitzt die Abdeckung 20 keine eigene Drehachse, d. h. sie wird nicht selbst durch eine eigene Drehvorrichtung, sondern passiv durch den angetriebenen Substrathalter gedreht. Würde die Abdeckung durch eine eigene Drehvorrichtung aktiv gedreht werden, wäre eine komplizierte Anpassung und Ausrichtung der dabei entstehenden zwei Drehachsen zueinander notwendig.

Obwohl die Erfindung anhand bevorzugter Ausführungsbeispiele der Erfindung beschrieben wurde, sei bemerkt, daß die Erfindung nicht darauf beschränkt ist. Beispielsweise könnte die Abdeckung 20 für den Schleudervorgang auch mit Elektromagneten oder durch andere Mittel, wie z. B. eine mechanische Klemmvorrichtung am Substrathalter befestigt werden. Auch ist eine Reinigung der Abdeckung nicht gleichzeitig mit dem Schleudervorgang erforderlich, und sie könnte auch mittels einer Bürste vor oder während des Schleudervorgangs erfolgen.

## Patentansprüche

1. Vorrichtung (1) zum Beschichten von Substraten (13), mit einem Substrathalter (5) an dem das Substrat derart gehalten ist, daß eine zu beschichtende Substratfläche (15) frei liegt und nach unten weist, und einer Vorrichtung zum Drehen des Substrathalters (5), **gekennzeichnet durch** eine am Substrathalter (5) befestigbare Abdeckung (20), die gemeinsam mit dem Substrathalter (5) eine abgedichtete, das Substrat (13) aufnehmende Kammer (36) bildet.

2. Vorrichtung (1) nach Anspruch 1, **gekennzeichnet durch** eine Halteeinrichtung (50) am Substrathalter (5) zum Halten des Substrats (13) mit Unterdruck.

3. Vorrichtung (1) nach Anspruch 1 oder 2, **gekennzeichnet durch** eine Halteeinrichtung (18; 54) am Substrathalter (5) zum Halten der Abdekkung (20) mit Unterdruck.

4. Vorrichtung (1) nach einem der vorhergehenden Ansprüche, **dadurch gekennzeichnet, daß** die Halteeinrichtungen (50; 18, 54) für das Substrat (13) und für die Abdeckung (20) mit einer gemeinsamen Unterdruckquelle verbunden sind.

5. Vorrichtung (1) nach einem der vorhergehenden Ansprüche, **dadurch gekennzeichnet, daß** die Halteeinrichtungen (50; 18, 54) für das Substrat (13) und für die Abdeckung (20) unabhängig voneinander ansteuerbar sind.

6. Vorrichtung (1) nach einem der vorhergehenden Ansprüche, **gekennzeichnet durch** wenigstens eine den Unterdruckbereich zwischen dem Substrathalter (5) und der Abdeckung (20) begrenzende Dichtung.

7. Vorrichtung (1) nach einem der vorhergehenden Ansprüche, **gekennzeichnet durch** eine Vertiefung (12) im Substrathalter (5) zur wenigstens teilweisen Aufnahme des Substrats (13).

8. Vorrichtung (1) nach einem der vorhergehenden Ansprüche, **gekennzeichnet durch** eine Zentriereinrichtung (16; 66) zum gegenseitigen Zentrieren der Abdeckung (20) und des Substrathalters (5).

9. Vorrichtung (1) nach einem der vorhergehenden Ansprüche, **gekennzeichnet durch** wenigstens eine Zentrierschräge (16; 66) am Substrathalter und/oder an der Abdeckung.

10. Vorrichtung (1) nach einem der vorhergehenden Ansprüche, **dadurch gekennzeichnet, daß** die Abdeckung (20) zu einer Mittelachse (C) symmetrisch ist.

11. Vorrichtung (1) nach einem der vorhergehenden Ansprüche, **gekennzeichnet durch** eine Aussparung (32) im Außenbereich des die Kammer definierenden Teils der Abdeckung (20).

12. Vorrichtung (1) nach einem der vorhergehenden Ansprüche, **dadurch gekennzeichnet, daß** sich die Aussparung (32) nach außen verjüngt.

13. Vorrichtung (1) nach einem der vorhergehenden Ansprüche, **dadurch gekennzeichnet, daß** die Aussparung (32) auf ihrer zum Substrathalter weisenden Seite (60) abgeschrägt ist.

14. Vorrichtung (1) nach einem der vorhergehenden Ansprüche, **dadurch gekennzeichnet, daß** die Abdeckung (20) zu ihrer Mittelebene (B) symmetrisch ist.

15. Vorrichtung (1) nach einem der vorhergehenden Ansprüche, **gekennzeichnet durch** eine Einrichtung zum Wenden der Abdeckung (20).

16. Vorrichtung (1) nach einem der vorhergehenden Ansprüche, **gekennzeichnet durch** eine Aufnahme (22) zum Halten der Abdeckung (20).

17. Vorrichtung (1) nach einem der vorhergehenden Ansprüche, **gekennzeichnet durch** eine Einrichtung zum Anheben und Absenken der Aufnahme (22).

18. Vorrichtung (1) nach einem der vorhergehenden Ansprüche, **gekennzeichnet durch** eine Spül- und/oder Trocknungsvorrichtung (40) für die Abdeckung (20).

19. Vorrichtung (1) nach einem der vorhergehenden Ansprüche, **dadurch gekennzeichnet, daß** die Spül- und/oder Trocknungsvorrichtung (40) Teil der Aufnahme (22) ist und wenigstens eine auf die Abdeckung (20) und/oder die Aussparung (32) gerichtete Düse (40) aufweist.

20. Vorrichtung (1) nach einem der vorhergehenden Ansprüche, **dadurch gekennzeichnet, daß** wenigstens eine Düse (40) mit einem Spülund/oder Trocknungsfluid beaufschlagbar ist.

21. Vorrichtung (1) nach einem der vorhergehenden Ansprüche, **dadurch gekennzeichnet, daß** das Spülfluid ein Lösungsmittel enthält.

22. Verfahren zum Beschichten von Substraten (13), bei dem das Substrat (13) derart an einem Substrathalter (5) gehalten ist, daß eine zu beschichtende Substratfläche (15) frei liegt und nach unten weist und das Substrat (13) mit dem Substrathalter (5) gedreht wird, **dadurch gekennzeichnet, daß** eine Abdeckung (20) am Substrathalter (5) befestigt wird, die gemeinsam mit dem Substrathalter (5) eine abgedichtete Kammer (36) für das Substrat (5) bildet.

23. Verfahren nach Anspruch 29, **dadurch gekennzeichnet, daß** das Substrat (13) mit Unterdruck am Substrathalter (5) gehalten wird.

24. Verfahren nach einem der Ansprüche 22 oder 23, **dadurch gekennzeichnet, daß** die Abdeckung (20) mit Unterdruck am Substrathalter (5) gehalten wird.

25. Verfahren nach einem der Ansprüche 22 bis 24, **dadurch gekennzeichnet, daß** die Abdeckung (20) und der Substrathalter vor dem Befestigen zueinander zentriert werden.

26. Verfahren nach einem der Ansprüche 22 bis 25, **dadurch gekennzeichnet, daß** die Befestigung der Abdeckung (20) nach der Drehbehandlung unabhängig von der Befestigung des Substrats (13) gelöst wird.

27. Verfahren nach einem der Ansprüche 22 bis 26, **dadurch gekennzeichnet, daß** die vom Substrat (13) abgewandte Seite der Abdeckung (20) während des Drehvorgangs gespült und/oder getrocknet wird.

28. Verfahren nach einem der Ansprüche 22 bis 27, **dadurch gekennzeichnet, daß** ein Spül- oder Trocknungsfluid über wenigstens eine Düse (40) auf die Abdeckung geleitet wird.

29. Verfahren nach einem der Ansprüche 22 bis 27, **dadurch gekennzeichnet, daß** die Abdeckung (20) zwischen aufeinanderfolgenden Drehvorgängen gewendet wird.

## Claims

1. Device (1) for coating substrates (13), with a substrate holder (5) at which the substrate is held in such a manner that a substrate surface (15) to be coated lies free and faces downwardly, and a device for rotating the substrate holder (5), **characterised by** a cover (20) which is fastenable to the substrate holder (5) and which forms together with the substrate holder (5) a sealed chamber (36) receiving the substrate (13).

2. Device (1) according to claim 1, **characterised by** a holding device (50) at the substrate holder (5) for holding the substrate (13) by underpressure.

3. Device (1) according to claim 1 or 2, **characterised by** a holding device (18; 54) at the substrate holder (5) for holding the cover (20) by underpressure.

4. Device (1) according to one of the preceding claims, **characterised in that** the holding devices (50; 18, 54) for the substrate (13) and for the cover (20) are connected with a common source of underpressure.

5. Device (1) according to one of the preceding claims, **characterised in that** the holding devices (50; 18, 54) for the substrate (13) and for the cover (20) are controllable independently of one another.

6. Device (1) according to one of the preceding claims, **characterised by** at least one seal bounding the underpressure region between the substrate holder (5) and the cover (20).

7. Device (1) according to one of the preceding claims, **characterised by** a depression (12) in the substrate holder (5) for at least partial reception of the substrate (13).

8. Device (1) according to one of the preceding claims, **characterised by** a centring device (16; 66) for mutual centring of the cover (20) and the substrate holder (5).

9. Device (1) according to one of the preceding claims, **characterised by** at least one centring chamfer (16; 66) at the substrate holder and/or at the cover.

10. Device (1) according to one of the preceding claims, **characterised in that** the cover (20) is symmetrical with respect to a centre axis (C).

11. Device (1) according to one of the preceding claims, **characterised by** a recess (32) in the outer region of the part of the cover (20) defining the chamber.

12. Device (1) according to one of the preceding claims, **characterised in that** the recess (32) tapers downwardly.

13. Device (1) according to one of the preceding claims, **characterised in that** the recess (32) is chamfered on its side (60) facing the substrate holder.

14. Device (1) according to one of the preceding claims, **characterised in that** the cover (20) is symmetrical with respect to its centre plane (B).

15. Device (1) according to one of the preceding claims, **characterised by** equipment for turning over the cover (20).

16. Device (1) according to one of the preceding claims, **characterised by** a receptacle (22) for holding the cover (20),

17. Device (1) according to one of the preceding claims, **characterised by** equipment for raising and lowering the receptacle (22).

18. Device (1) according to one of the preceding claims, **characterised by** a washing and/or drying device (40) for the cover (20).

19. Device (1) according to one of the preceding claims, **characterised in that** the washing and/or drying device (40) is part of the receptacle (22) and comprises at least one nozzle (40) directed onto the cover (20) and/or the recess (32).

20. Device (1) according to one of the preceding claims, **characterised in that** at least one nozzle (40) is loadable with a washing and/or drying fluid.

21. Device (1) according to one of the preceding claims, **characterised in that** the washing fluid contains a solvent.

22. Method of coating substrates (13), in which the substrate (13) is held at a substrate holder (5) in such a manner that a substrate surface (15) to be coated lies free and faces downwardly and the substrate (13) is rotated together with the substrate holder (5), **characterised in that** a cover (20) is fastened to the substrate holder (5) and forms together with the substrate holder (5) a sealed chamber (36) for the substrate (5).

23. Method according to claim 29, **characterised in that** the substrate (13) is held at the substrate (5) by underpressure.

24. Method according to one of claims 22 and 23, **characterised in that** the cover (20) is held at the substrate holder (5) by underpressure.

25. Method according to one of claims 22 to 24, **characterised in that** the cover (20) and the substrate holder are centred relative to one another before the fastening.

26. Method according to one of claims 22 to 25, **characterised in that** the fastening of the cover (20) is released after the rotary handling independently of the fastening of the substrate (13).

27. Method according to one of claims 22 to 28, **characterised in that** the side of the cover (20) remote from the substrate (13) is washed and/or dried during the process of rotating.

28. Method according to one of claims 22 to 27, **characterised in that** a washing or drying fluid is conducted to the cover by way of at least one nozzle (40).

29. Method according to one of claims 22 to 27, **characterised in that** the cover (20) is turned over between successive processes of rotation.

## Revendications

1. Dispositif (1) de revêtement de substrats (13), avec un porte-substrat (5) auquel le substrat est retenu de façon qu'une face de substrat (15) à revêtir repose librement et soit dirigée vers le bas, et un dispositif pour tourner le porte-substrat (5), **caractérisé par** un recouvrement (20) pouvant être fixé au porte-substrat (5) qui forme conjointement avec le porte-substrat (5) une chambre étanche (36) recevant le substrat (13).

2. Dispositif (1) selon la revendication 1, **caractérisé par** une installation de retenue (50) au porte-substrat (5) pour tenir le substrat (13) à dépression.

3. Dispositif (1) selon la revendication 1 ou 2, **caractérisé par** une installation de retenue (18;54) au porte-substrat (5) pour tenir le recouvrement (20) à dépression.

4. Dispositif (1) selon l'une des revendications précédentes, **caractérisé en ce que** les installations de retenue (50; 18, 54) pour le substrat (13) et pour le recouvrement (20) sont reliées à une source de dépression commune.

5. Dispositif (1) selon l'une des revendications précédentes, **caractérisé en ce que** les installations de retenue (50; 18, 54) pour le substrat (13) et pour le recouvrement (20) peuvent être commandées indépendamment l'une de l'autre.

6. Dispositif (1) selon l'une des revendications précédentes, **caractérisé par** au moins une garniture d'étanchéité délimitant la zone de dépression entre le porte-substrat (5) et le recouvrement (20).

7. Dispositif (1) selon l'une des revendications précédentes, **caractérisé par** un creux (12) dans le porte-substrat (5) pour la réception au moins partielle du substrat (13).

8. Dispositif (1) selon l'une des revendications précédentes, **caractérisé par** une installation de centrage (16; 66) pour le centrage mutuel du recouvrement (20) et du porte-substrat (5).

9. Dispositif (1) selon l'une des revendications précédentes, **caractérisé par** au moins un biais de centrage (16; 66) au porte-substrat et/ou au recouvrement.

10. Dispositif (1) selon l'une des revendications précédentes, **caractérisé en ce que** le recouvrement (20) est symétrique à un axe médian (C).

11. Dispositif (1) selon l'une des revendications précédentes, **caractérisé par** un évidement (32) dans la zone extérieure de la partie définissant la chambre du recouvrement (20).

12. Dispositif (1) selon l'une des revendications précédentes, **caractérisé en ce que** l'évidement (32) diminue vers l'extérieur.

13. Dispositif (1) selon l'une des revendications précédentes, **caractérisé en ce que** l'évidement (32) est chanfreiné sur son côté (60) orienté vers le porte-substrat.

14. Dispositif (1) selon l'une des revendications précédentes, **caractérisé en ce que** le recouvrement (20) est symétrique à son axe médian (B).

15. Dispositif (1) selon l'une des revendications précédentes, **caractérisé par** une installation pour retourner le recouvrement (20).

16. Dispositif (1) selon l'une des revendications précédentes, **caractérisé par** un logement (22) pour retenir le recouvrement (20).

17. Dispositif (1) selon l'une des revendications précédentes, **caractérisé par** une installation pour relever et abaisser le logement (22).

18. Dispositif (1) selon l'une des revendications précédentes, **caractérisé par** un dispositif de rinçage et/ou de séchage (40) pour le recouvrement (20).

19. Dispositif (1) selon l'une des revendications précédentes, **caractérisé en ce que** le dispositif de rinçage et/ou de séchage (40) constitue une partie du logement (22) et présente au moins une buse (40) dirigée sur le recouvrement (20) et/ou l'évidement (32).

20. Dispositif (1) selon l'une des revendications précédentes, **caractérisé en ce qu'**au moins une buse (40) peut être chargée par un fluide de rinçage et/ou de séchage.

21. Dispositif (1) selon l'une des revendications précédentes, **caractérisé en ce que** le fluide de rinçage contient un solvant.

22. Procédé de revêtement de substrats (13), où le substrat (13) est retenu de telle sorte à un porte-substrat (5) qu'une face de substrat (15) à revêtir repose librement et soit orientée vers le bas et que le subtrat (13) est tourné avec le porte-substrat (5), **caractérisé en ce qu'**un recouvrement (20) est fixé au porte-substrat (5) qui forme conjointement avec le porte-substrat (5) une chambre étanche (36) pour le substrat (5).

23. Procédé selon la revendication 22, **caractérisé en ce que** le substrat (13) est retenu à dépression au porte-substrat (5).

24. Procédé selon l'une des revendications 22 ou 23, **caractérisé en ce que** le recouvrement (20) est retenu à dépression au porte-substrat (5).

25. Procédé selon l'une des revendications 22 à 24, **caractérisé en ce que** le recouvrement (20) et le porte-substrat sont centrés l'un relativement à l'autre avant la fixation.

26. Procédé selon l'une des revendications 22 à 25, **caractérisé en ce que** la fixation du recouvrement (20), après le traitement tournant, est relâchée indépendamment de la fixation du substrat (13).

27. Procédé selon l'une des revendications 22 à 26, **caractérisé en ce que** le côté du recouvrement (20) éloigné du substrat (13) est rincé et/ou séché pendant l'opération tournante.

28. Procédé selon l'une des revendications 22 à 27, **caractérisé en ce qu'**un fluide de rinçage ou de séchage est guidé par au moins une buse (40) sur le recouvrement.

29. Procédé selon l'une des revendications 22 à 27, **caractérisé en ce que** le recouvrement (20) est retourné entre des opérations tournantes successives.
